# FASCICULE DE BREVET EUROPEEN

(11) **EP 0 298 879 B1**
(45) Date de publication et mention de la délivrance du brevet: **07.04.1993**
(21) Numéro de dépôt: 88420222.7
(22) Date de dépôt: 24.06.1988
(51) Int. Cl.: H01L 21/311, H01L 21/76

(54) **Procédé d'élimination des zones de nitrure ou d'oxynitrure de silicum**
Verfahren zum Entfernen von Teilen aus Siliciumnitrid oder Siliciumoxynitrid
Process for removing silicon nitride or oxynitride

(30) Priorité: 25.06.1987 FR 8709174
(43) Date de publication de la demande: 11.01.1989
(73) Titulaire: FRANCE TELECOM, 75015 Paris (FR)
(72) Inventeur: Straboni, Alain, F-38400 St Martin (FR); Berenguer, Marc, F-38420 Revel (FR); Vuillermoz, Bernard, F-3800 Grenoble (FR)
(74) Mandataire: de Beaumont, Michel

(56) Documents cités:
- EP-A- 0 142 450
- IEEE TRANSACTIONS ON ELECTRON DEVICES, vol. ED-26, no. 11, novembre 1979, page 1830; H.Q. VU et al.: "Selective oxidation of Silicon in RF-induced oxygen plasma"
- IBM TECHNICAL DISCLOSURE BULLETIN, vol. 19, no. 8, janvier 1977, page 2944, New York, US; A. BHATTACHARYYA et al.: "Low-temperature plasma conversion of silicon nitride to silicon dioxide"
- IBM TECHNICAL DISCLOSURE BULLETIN, vol. 24, no. 7B, décembre 1981, pages 3584-3585, New York, US; C.T. KROLL: "Simultaneous growth of thick and thin oxide via silicon nitride conversion"
- THIN SOLID FILMS, vol. 137, no. 2, 15 mars 1986, pages 235-242, Elsevier Sequoia, Amsterdam, NL; E.D. ATANASSOVA et al.: "The effect of R.F. plasma oxidation and the subsequent temperature annealing on the morphology of the silicon surface"
- APPLIED PHYSICAL LETTERS, vol. 48, no. 1, 6 janvier 1986, pages 27-29, American Institute of Physics; R.K. BROW et al.: "Oxidation resistant sol-gel derived silicon oxynitride thin films"

## Description

La présente invention concerne un procédé d'élimination de zones de nitrure ou d'oxynitrure de silicium. Ce procédé s'applique plus particulièrement à l'enlèvement de couches ou de zones de nitrure et/ou d'oxynitrure de silicium à la surface d'un substrat de silicium lors d'étapes préliminaires de fabrication d'un circuit intégré, c'est-à-dire lors des étapes de formation de zones d'isolement pour séparer des composants ou des ensembles de composants élémentaires.

Lors des étapes initiales de fabrication d'un circuit intégré, tant du type MOS que du type bipolaire, l'un des procédés classiques réside dans la formation de zones d'oxyde de silicium relativement épaisses, couramment appelées zones d'oxyde épais ou d'oxyde de champ destinées à séparer des îlots dans lesquels seront formés un ou plusieurs transistors ou autre composant élémentaire.

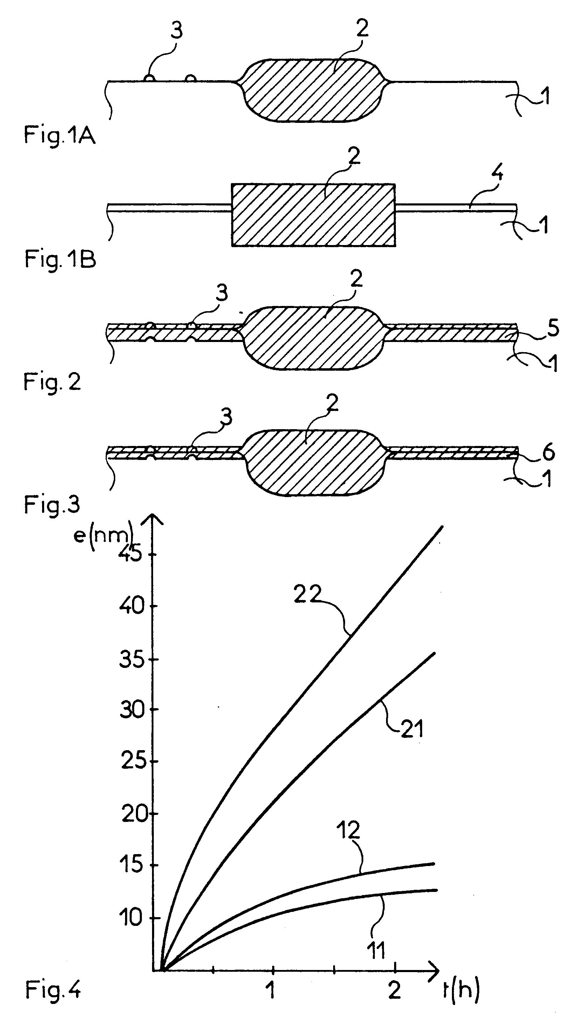

Le procédé le plus classique de formation de zones localisées d'oxyde de champ sur un substrat de silicium, dit procédé LOCOS, consiste à faire croître une couche mince d'oxyde de silicium (SiO₂) puis à déposer une couche mince de nitrure de silicium (Si₃N₄). Ces couches sont ouvertes par gravure selon la configuration souhaitée puis la zone d'oxyde de champ est amenée à croître et ne se développe que dans les ouvertures, la couche de nitrure servant de masque à l'oxydation. Une fois l'oxyde développé, on élimine la couche de nitrure de silicium, généralement par des procédés d'attaque chimique ; on maintient la couche mince de SiO₂ pour l'utiliser comme électrode de grille de transistors MOS ou un l'élimine pour arriver à une structure du type représenté en figure 1A. Dans cette figure, la référence 1 désigne le substrat de silicium, la référence 2 la zone d'oxyde de champ et la référence 3 des résidus de nitrure de silicium dont l'expérience montre qu'ils apparaissent inévitablement à la fin du processus.

Une variante du procédé LOCOS, appelée procédé SILO, consiste à utiliser comme sandwich antioxydation, un sandwich nitrure/silice/nitrure plutôt que simplement silice/nitrure. L'expérience montre que l'on obtient ainsi des zones d'oxyde de champ mieux délimitées sur les bords et que l'on minimise l'effet de bec d'oiseau. On se retrouve en fin de procédé avec une structure du type de celle représentée en figure 1B dans laquelle les mêmes références qu'en figure 1A désignent les mêmes couches. Mais cette fois, au lieu de résidus localisés de nitrure 3, il demeure une couche mince de nitrure 4.

D'autre part, il conviendra de souligner que le résidu de nitrure 3 et la couche de nitrure 4 ne sont généralement pas du nitrure de silicium stoechiométrique (Si₃N₄) mais plus généralement des composés complexes dits oxynitrures désignés par la formule générique SiOₓN_{y}.

Pour la réalisation de composants dans les zones entourées par l'oxyde de champ 2, il est impératif d'éliminer ces couches ou résidus d'oxynitrure qui viendraient autrement perturber les traitements ultérieurs et le fonctionnement des dispositifs formés.

Le procédé le plus simple pour atteindre ce résultat consiste à procéder à une attaque chimique avec des produits tels que H₃PO₄ qui attaquent le nitrure de silicium sélectivement par rapport à SiO₂ et à Si. Toutefois, ces procédés présentent l'inconvénient que l'attaque ne fonctionne plus de façon sélective ou très mal dans le cas d'un oxynitrure. D'autre part, de façon générale, on souhaite à l'heure actuelle dans les technologies de fabrication de circuits intégrés éviter le plus possible les procédés d'attaque chimique en phase liquide qui présentent toujours l'inconvénient que les conditions de pureté idéales ne sont pas toujours satisfaites. En effet, il est toujours difficile d'obtenir un produit chimique liquide parfaitement pur alors que pour un gaz cela est plus simplement possible.

En conséquence, on s'est dirigé vers des procédés d'oxydation thermique en présence d'un gaz, par exemple de la vapeur d'eau, pour transformer le nitrure de silicium en oxyde de silicium, après quoi ce dernier est éliminé par une gravure sélective par rapport au silicium. Un inconvénient bien évident de ces procédés, comme cela est représenté en figure 2, est que le nitrure 3, s'oxyde beaucoup plus lentement que le silicium nu ou recouvert de silice, 1, existant dans les régions voisines. C'est d'ailleurs pour cette raison que lors des étapes antérieures du procédé le nitrure a été utilisé pour éviter l'oxydation des couches sous-jacentes. Il se forme donc en surface une couche d'oxyde 5 beaucoup plus épaisse que la hauteur des résidus de nitrure, et la gravure pour éliminer cette couche 5 réduira l'épaisseur de l'oxyde de champ 2.

Par ailleurs, on connaît dans l'art antérieur, par exemple à partir du brevet français 2 555 360 déposé aux noms des inventeurs de la présente demande, un appareil d'oxydation en présence d'un plasma d'oxygène. Cet appareil est décrit pour l'oxydation de plaquettes de silicium. Il est proposé dans ce document d'effectuer des oxydations dans une plage préférentielle de pression de 20 à 50 milliTorr (2 à 7 pascals) et une plage préférentielie de températures comprise entre 500 et 800°C. Les diverses courbes représentées dans ce document indiquent que les vitesses de croissance sont sensiblement constantes, c'est-à-dire que l'épaisseur de la couche d'oxyde formée varie sensiblement linéairement avec la durée au moins jusqu'à des épaisseurs d'oxyde de l'ordre de 600 nm. Il n'est pas suggéré dans ce document d'oxyder du nitrure de silicium.

Un article de IBM Technical Disclosure Bulletin, volume 19, no 8, janvier 1977, page 2944 décrit l'oxydation dans un même réacteur à plasma d'oxygène d'une couche uniforme de nitrure de silicium puis d'une couche de silicium. Cet article ne suggère pas l'oxydation simultanée de silicium et de nitrure de silicium.

Un article de Thin Solid Films, volume 137, no 2, mars 1986, pages 235-242 concerne l'oxydation du silicium dans un plasma d'oxygène.

Un objet de la présente invention est de prévoir un procédé d'oxydation du nitrure de silicium en présence d'un plasma qui ne présente pas les inconvénients de l'art antérieur tels que décrits en relation avec la Figure 2.

La présente invention se base sur la découverte du fait que, dans certaines conditions opératoires, par exemple en utilisant un appareil du type décrit dans le brevet cité ci-dessus et en choisissant des plages données de pression et de température ainsi que des modes particuliers de polarisation électrique, on arrive à oxyder le nitrure de silicium à une vitesse sensiblement égale à la vitesse d'oxydation du silicium nu.

Ainsi, grâce à la présente invention, on évite les inconvénients exposés précédemment en relation avec la figure 2 du fait que l'oxydation du silicium en dehors des zones recouvertes de nitrure est faible. On évite donc, lors de la gravure ultérieure de la couche de silice, d'enlever une épaisseur de silice importante ce qui réduirait l'efficacité des zones d'oxyde de champ ou obligerait à faire croître initialement des couches plus épaisses.

Ces objets, caractéristiques et avantages ainsi que d'autres de la présente invention seront exposés plus en détail dans la description suivante d'exemples particuliers faite en relation avec les figures jointes parmi lesquelles :
les figures 1A, 1B et 2 décrites précédemment étaient destinées à illustrer l'état de la technique ;
la figure 3 représente une structure découlant de celle de la figure 1A après un traitement selon la présente invention ; et
la figure 4 représente des courbes illustrant des résultats obtenus selon la présente invention en ce qui concerne l'épaisseur oxydée e en fonction du temps t.

Dans les figures 1, 2 et 3, les épaisseurs ne sont pas tracées à l'échelle, ni d'une figure à l'autre, ni à l'intérieur d'une même figure.

La figure 3 illustre le résultat obtenu par la présente invention à savoir que, par un traitement selon la présente invention, le nitrure ou l'oxynitrure de silicium 3 est oxydé sensiblement à la même vitesse que le silicium nu pour former une couche de silice 6 qui a une épaisseur légèrement supérieure à l'épaisseur maximale des résidus de nitrure de silicium 3 ou de la couche de nitrure de silicium 4 des figures 1A et 1B, respectivement.

Ce procédé peut paraître particulièrement avantageux dans le cas où l'on part d'une structure telle que celle de la figure 1A mais il faut bien noter que le cas d'une structure de départ telle que celle de la figure 1B est en fait très analogue puisque, lors d'une oxydation d'une couche continue de nitrure de silicium 4, il existe toujours des emplacements où le nitrure est oxydé plus vite qu'ailleurs, soit en raison d'inégalités d'épaisseur, soit en raison de défauts structurels de la couche, soit aux limites des masques, et l'on se retrouve donc dans le même cas qu'en figure 1A.

Le résultat illustré en figure 3 a été obtenu en utilisant un appareil tel que décrit dans le brevet français 2 555 360 qui sera considéré ici comme connu et comme faisant partie intégrante de la présente description.

Une différence de structure existe toutefois entre l'appareil utilisé selon la présente invention et l'appareil décrit dans ce brevet antérieur à savoir que les plaquettes de silicium au lieu d'être connectées électriquement à une électrode dont on contrôle la polarisation sont électriquement flottantes dans la zone de diffusion du plasma.

D'autre part, alors que dans l'art antérieur, on préconisait (pour l'oxydation de silicium) des températures de fonctionnement relativement faibles, de préférence comprises entre 500 et 800°C, on procédera selon la présente invention à des températures nettement plus élevées, par exemple de l'ordre de 750 à 950°C. Les plages de pression d'oxygène seront du même ordre de grandeur que dans le document cité, c'est-à-dire par exemple comprises entre 20 et 50 milliTorr (2,5 et 7 Pa).

La figure 4 représente l'épaisseur e en nanomètres (nm) d'oxyde formée en fonction du temps t en heures au cours du processus selon la présente invention pour diverses valeurs des paramètres de pression et de température. Ces courbes représentent l'épaisseur d'oxyde formé à partir de nitrure de silicium ou de silicium nu.

On note à partir de ces courbes qu'il est possible d'ajuster la vitesse d'oxydation en faisant varier les paramètres de pression P et de température T. Pour chacune de ces courbes les paramètres sont indiqués dans le tableau ci-dessous. Dans tous les cas la puissance appliquée à l'appareil restait constante (600 W).

| Numéro de Courbe | Température (°C) | Pression Torr |
|---|---|---|
| 11 | 750 | 10⁻² |
| 12 | 750 | 10⁻¹ |
| 21 | 950 | 3.10⁻² |
| 22 | 950 | 10⁻¹ |

On notera par ailleurs que la vitesse de croissance diminue en fonction du temps pour atteindre une valeur sensiblement nulle (voir en particulier les courbes 11 et 12). Ainsi, dans des conditions expérimentales données, l'épaisseur d'oxyde formée tend vers une valeur maximale finie réglable par le choix de la pression et de la température. On peut donc créer des couches d'oxyde d'épaisseur très uniforme et prédéterminée.

## Revendications

1. Procédé d'élimination de zones de nitrure et/ou d'oxynitrure de silicium (3) à la surface d'un substrat de silicium (1), consistant à oxyder le nitrure ou oxynitrure pour le transformer en SiO₂ puis à graver sélectivement ce SiO₂ (6) par rapport au silicium sous-jacent, caractérisé en ce que l'oxydation est effectuée dans un réacteur d'oxydation à plasma d'oxygène dans des conditions telles que les vitesses d'oxydation du nitrure et/ou de l'oxynitrure, et du silicium sont du même ordre de grandeur.

2. Procédé selon la revendication 1, caractérisé en ce que le substrat de silicium est une couche de silicium formée au-dessus d'une couche mince d'oxyde de silicium.

3. Procédé selon la revendication 1 ou 2, caractérisé en ce que le réacteur satisfait aux conditions suivantes :
- les plaquettes à traiter sont maintenues à un potentiel flottant ;
- la pression d'oxygène est comprise entre 2,5 et 7 Pa (20 et 50 milliTorr) ; et
- la température est comprise entre 750 et 950°C.

4. Procédé selon la revendication 3, caractérisé en ce que la pression et la température de fonctionnement sont prédéterminées pour l'obtention d'une épaisseur d'oxyde choisie.

## Claims

1. A method for eliminating areas of silicon nitride and/or silicon oxinitride (3) from the surface of a silicon substrate (1) consisting in oxidizing said nitride or oxinitride to transform same into SiO₂, then etching said resulting SiO₂ (6) selectively with respect to the underlying silicon, characterized in that said oxidation is performed in an oxidation reactor using an oxygeneous plasma under such conditions that the oxidation rates of the nitride and/or oxinitride, and of the silicon have an equal range of magnitude.

2. A method according to claim 1, characterized in that said silicon substrate is a silicon layer formed on top of a thin silicon oxide layer.

3. A method according to claim 1 or 2, characterized in that said reactor meets the following conditions:
- the wafers to be processed are maintained at a floating voltage;
- the oxygen pressure ranges from 2.5 to 7 Pa (20 to 50 millitors); and
- the temperature ranges from 750°C to 950°C.

4. A method according to claim 3, characterized in that said operating pressure and temperature are predetermined to provide a desired oxide thickness.

## Patentansprüche

1. Verfahren zum Entfernen von Zonen (3) aus Siliciumnitrid und/oder Siliciumoxynitrid auf der Oberfläche eines Siliciumsubstrates (1), bei dem das Nitrid oder Oxynitrid oxidiert wird, um es in SiO₂ umzubilden, und anschließend das SiO₂ (6) selektiv im Hinblick auf das darunter liegende Silicium geätzt wird, dadurch gekennzeichnet, daß die Oxidation in einem Oxidationsreaktor mit Sauerstoffplasma unter solchen Bedingungen ausgeführt wird, daß die Oxidationsgeschwindigkeiten des Nitrids und/oder des Oxynitrids sowie des Siliciums von gleicher Größenordnung sind.

2. Verfahren nach Anspruch 1, dadurch gekennzeichnet, daß das Siliciumsubstrat eine Siliciumschicht ist, die auf einer dünnen Schicht aus Siliciumoxid ausgebildet ist.

3. Verfahren nach einem der Ansprüche 1 oder 2, dadurch gekennzeichnet, daß der Reaktor den folgenden Bedingungen genügt:
- die zu behandelnden Plättchen werden auf Schwebepotential gehalten;
- der Sauerstoffdruck liegt zwischen 2,5 und 7 Pa (20 und 30 milliTorr); und
- die Temperatur liegt zwischen 750 und 950°C.

4. Verfahren nach Anspruch 1, dadurch gekennzeichnet, daß der Betriebsdruck und die Betriebstemperatur vorbestimmt sind, um eine gewünschte Schichtdicke des Oxids zu erhalten.
